# EUROPÄISCHE PATENTSCHRIFT

(11) **EP 1 048 087 B1**
(45) Veröffentlichungstag und Bekanntmachung des Hinweises auf die Patenterteilung: **06.10.2004**
(21) Anmeldenummer: 99950459.0
(22) Anmeldetag: 29.07.1999
(51) Int. Cl.: H01L 41/24, H01L 41/083

(54) **VERFAHREN ZUR HERSTELLUNG PIEZOELEKTRISCHER AKTOREN**
METHOD FOR PRODUCING PIEZOELECTRIC ACTUATORS
PROCEDE DE PRODUCTION D'ACTEURS PIEZO-ELECTRIQUES

(30) Priorität: 03.11.1998 DE 19850610
(43) Veröffentlichungstag der Anmeldung: 02.11.2000
(73) Patentinhaber: ROBERT BOSCH GMBH, 70442 Stuttgart (DE)
(72) Erfinder: STIER, Hubert, D-71679 Asperg (DE); HOHL, Guenther, D-70569 Stuttgart (DE); BOECKING, Friedrich, D-70499 Stuttgart (DE)
(86) Internationale Anmeldenummer: PCT/DE1999/002335
(87) Internationale Veröffentlichungsnummer: WO 2000/026972

(56) Entgegenhaltungen:
- EP-A- 0 550 829
- EP-A- 0 736 386

## Beschreibung

### Stand der Technik

Die Erfindung geht aus von einem Verfahren zur Herstellung piezoelektrischer Aktoren, insbesondere für Brennstoffeinspritzventile, nach der Gattung des Hauptanspruchs.

Piezoelektrische Aktoren, insbesondere zur Betätigung von Brennstoffeinspritzventilen, sind in vielfältigen Bauformen beispielsweise aus der DE 195 00 706 Al oder der DE 43 06 073 C1 bekannt. Die piezoelektrischen Aktoren bestehen aus mehreren übereinander gestapelten piezoelektrischen Schichten, die jeweils an einer Oberfläche mit einer Elektrode beschichtet sind. Übliche Piezoaktoren bestehen aus mehreren hundert derart übereinander geschichteten piezoelektrischen Schichten. Auf diese Weise wird ein relativ großer Betätigungshub erreicht. Wie z. B. in der DE 37 13 697 A1 näher dargestellt, müssen die Elektroden der einzelnen piezoelektrischen Schichten alternierend mit einer Spannungsquelle verbunden werden, um in den einzelnen Schichten ein in gleicher Richtung ausgerichtetes elektrisches Feld zu erzeugen. Dabei ist jede zweite Elektrode mit einem ersten Pol einer Spannungsquelle verbunden, während die dazwischenliegenden Elektroden mit einem zweiten Pol einer Spannungsquelle verbunden sind.

Aus der DE 195 34 445 A1 sind piezoelektrische Aktoren mit einer zentralen Durchdringung bekannt.

Bei der Herstellung der piezoelektrischen Aktoren ist es bisher üblich, zunächst dünne Folien aus einem piezoelektrischen Keramikwerkstoff herzustellen und diese an der Oberfläche beispielsweise durch Aufdampfen oder Aufsputtern mit Elektroden zu beschichten. Sodann werden die Folien aufeinandergestapelt und verpreßt. Anschließend erfolgt ein Sintern der gestapelten Folien, so daß die einzelnen Schichten miteinander verbacken werden. Schließlich wird der Stapel in einzelne Aktoren beispielsweise durch Zersägen zerlegt.

Sofern die zur Betätigung von Brennstoffeinspritzventilen eingesetzten Aktoren zur Erzielung einer kompakten Bauform eine zentrale Durchströmungsöffnung für den Brennstoff aufweisen sollen, wurde diese zentrale Durchströmungsöffnung bislang durch einen nach dem Stapeln und Sintern vorgenommenen spanenden Bearbeitungsschritt, in der Regel durch Bohren, eingebracht. Dieser spanende Bearbeitungsschritt ist jedoch aufwendig, zumal die gesinterten Keramikschichten eine relativ hohe Härte aufweisen. Ferner mußte bislang die durch Bohren hergestellte zentrale Durchströmungsöffnung zur Vermeidung von Kurzschlüssen zwischen den Elektroden durch einen Feinbearbeitungsschritt nachbehandelt werden. Besonders nachteilig ist ferner, daß sich durch Bohren lediglich runde Durchströmungsöffnungen herstellen lassen. In der Praxis besteht jedoch das Bedürfnis, Durchströmungsöffnungen in anderer Konfiguration herzustellen. Durch das Zersägen der gestapelten und gesinterten Folien in die einzelnen Aktoren entstehen Aktoren mit rechteckigem Querschnitt. Zum Einbau in Brennstoffeinspritzventile mit einer hohlzylinderförmigen Gehäusekontur sind jedoch zur Einsparung des Einbauplatzes piezoelektrische Aktoren mit einer zylinderförmigen Außenkontur vorteilhaft. Um aus den durch Zersägen hergestellten quaderförmigen Aktoren mit rechteckigem Querschnitt zylinderförmige Aktoren mit rundem Querschnitt herzustellen, müssen die Aktoren nochmals durch Fräsen oder Drehen nachbearbeitet werden, was relativ aufwendig ist und hohe Fertigungskosten hervorruft.

### Vorteile der Erfindung

Das erfindungsgemäße Verfahren zur Herstellung piezoelektrischer Aktoren mit den kennzeichnenden Merkmalen des Anspruchs 1 hat demgegenüber den Vorteil, daß sich die zentrale Durchströmungsöffnung für die einzelnen Aktoren dadurch vereinfacht herstellen läßt, daß in die Folien bereits vor dem Stapeln und Sintern entsprechende Ausnehmungen eingebracht werden, die nach dem Stapeln der Folien die zentrale Durchströmungsöffnung des Aktors bilden. Dazu sind die Folien beim Stapeln exakt fluchtend übereinander anzuordnen, was beispielsweise durch an den Folien vorgesehene Zentrierbohrungen ohne Schwierigkeiten möglich ist. Durch die exakte Ausrichtung der Folien übereinander wird eine zentrale Durchströmungsöffnung mit glatter Innenwandung geschaffen, die keiner Nachbearbeitung bedarf. Das erfindungsgemäße Verfahren ist daher besonders bei einer Serienfertigung äußerst rationell einsetzbar. Eine spanende Bearbeitung ist nicht erforderlich.

Ein weiterer wesentlicher Vorteil besteht darin, daß nicht nur kreisförmige Durchströmungsöffnungen, sondern auch Durchströmungsöffnungen mit anderen Konturen herstellbar sind.

Durch die in den Unteransprüchen aufgeführten Maßnahmen sind vorteilhafte Weiterbildungen und Verbesserungen des im Anspruchs 1 angegebenen Verfahrens möglich.

Besonders vorteilhaft können mit dem erfindungsgemäßen Verfahren nicht nur die Innenkonturen für die zentrale Durchströmungsöffnung, sondern auch die Außenkonturen der Aktoren vorgeformt werden. Dazu wird jede Folie vor dem Stapeln so ausgeformt, daß diese mehrere Aktorbereiche, die nach dem Stapeln die Aktoren bilden, aufweisen, die über Verbindungsstege mit einem Rahmenbereich, der die Aktorenbereiche zusammenhält, verbunden sind. Außerhalb der Verbindungsstege weisen die Aktorbereiche bereits ihre endgültige Kontur auf, wobei aus den Folien die Bereiche außerhalb der Aktorbereiche, der Verbindungsstege und des Rahmenbereichs beispielsweise durch Stanzen oder Laserschneiden herausgetrennt werden. Besonders vorteilhaft ist dabei, daß sich beispielsweise auch runde Aktoraußenkonturen herstellen lassen, ohne daß die gestapelten und gesinterten Aktoren durch einen spanenden Fertigungsschritt, beispielsweise durch Drehen oder Fräsen, nachbearbeitet werden müssen. Aktoren mit runder Außenkontur sind für die Verwendung bei Brennstoffeinspritzventilen besonders geeignet, da diese in hohlzylindrische Ventilgehäuse platzsparend einbaubar sind.

Der Rahmenbereich der Folien besteht vorteilhaft aus einem Außenrahmen und mehreren zeilenartig in dem Außenrahmen angeordneten Quersprossen, an welchen die Aktorbereiche über die Verbindungsstege befestigt sind. Nach dem Stapeln und Sintern der Folien werden die einzelnen Aktoren aus den Stapeln herausgetrennt, indem die Verbindungsstege beispielsweise durch Laserschneiden oder durch Ausbrechen durchtrennt werden. Die zu durchtrennende Strecke an den Verbindungsstegen ist dabei vergleichsweise kurz.

In vorteilhafter Weise werden die Elektroden so auf die Folien aufgebracht, daß diese einen vorgegebenen Abstand von den Ausnehmungen und Außenkonturen der Aktoren aufweisen. Dadurch wird sichergestellt, daß die Elektroden nicht bis zu der Außenfläche der Aktoren bzw. bis zu der zentralen Durchströmungsöffnung reichen und deshalb von der Umgebung des Aktors bzw. von dem in der zentralen Durchströmungsöffnung strömenden Brennstoff isoliert sind.

### Zeichnung

Ausführungsbeispiele der Erfindung sind in der Zeichnung vereinfacht dargestellt und in der nachfolgenden Beschreibung näher erläutert. Es zeigen:
- Fig. 1: einen piezoelektrischen Aktor gemäß dem Stand der Technik in einer perspektivischen, geschnittenen Darstellung;
- Fig. 2: eine bearbeitete Folie aus einem piezoelektrischen Keramikwerkstoff entsprechend einem ersten Ausführungsbeispiel der Erfindung;
- Fig. 3: eine bearbeitete Folie aus einem piezoelektrischen Keramikwerkstoff entsprechend einem zweiten Ausführungsbeispiel der Erfindung; und
- Fig. 4: ein Ausführungsbeispiel eines Brennstoffeinspritzventils mit einem erfindungsgemäß hergestellten piezoelektrischen Aktor in einer geschnittenen Darstellung.

### Beschreibung der Ausführungsbeispiele

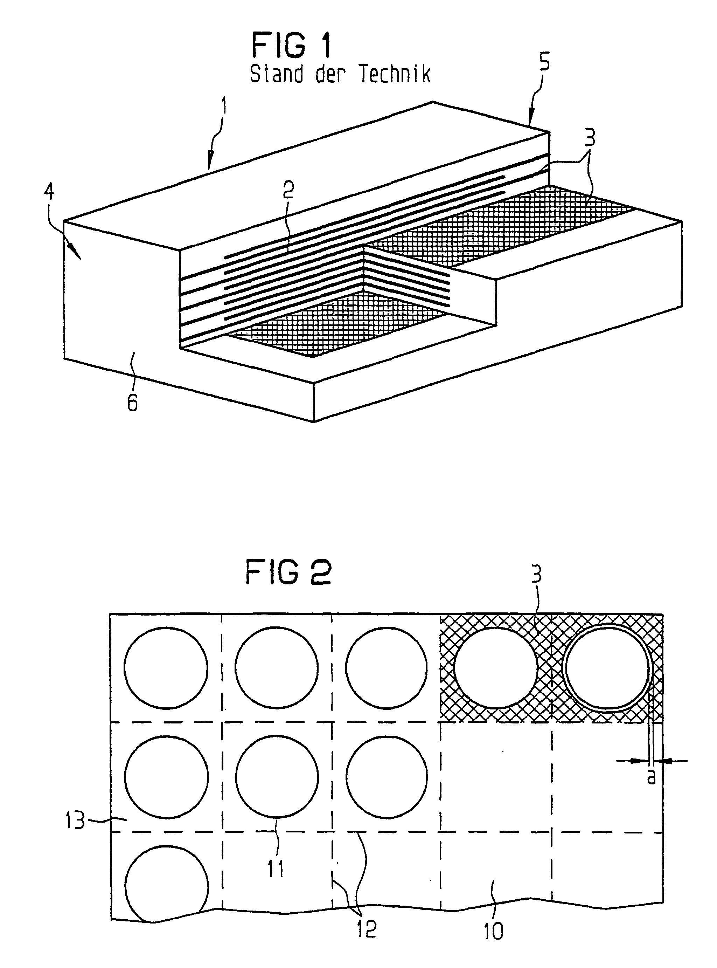

Zum besseren Verständnis der Erfindung zeigt Fig. 1 einen piezoelektrischen Aktor 1 entsprechend dem Stand der Technik in einer gestuft geschnittenen Darstellung.

Der piezoelektrische Aktor 1 besteht aus einem Keramikblock 2 aus einem piezoelektrischen Keramikwerkstoff, in welchen Elektroden 3 eingebettet sind. An den beiden Querseiten 4 und 5 des piezoelektrischen Aktors 1 befindet sich jeweils eine Leiterbahn, wobei in Fig. 1 nur die Leiterbahn 6 an der ersten Querseite 4 erkennbar ist. Die in gleicher Weise an der zweiten Querseite 5 vorhandene Leiterbahn ist in Fig. 1 verdeckt. Jede zweite Elektrode 3 ist mit der an der ersten Querseite 4 vorgesehenen ersten Leiterbahn 6 verbunden, während die dazwischenliegenden Elektroden 3 mit der an der zweiten Querseite 5 vorgesehenen Leiterbahn verbunden sind. Durch Anlegen einer elektrischen Spannung zwischen den an den Querseiten 4 und 5 vorhandenen Leiterbahnen 6 entsteht ein elektrisches Feld, das je nach Kristallrichtung zu einer Dehnung oder Kontraktion des piezoelektrischen Aktors 1 führt. Diese Dehnung oder Kontraktion kann beispielsweise zur Betätigung eines Ventilschließkörpers eines Brennstoffeinspritzventils ausgenutzt werden.

Ein bekanntes Herstellungsverfahren zur Herstellung derartiger piezoelektrischer Aktoren 1 besteht darin, daß zunächst Folien aus einem piezoelektrischen Keramikwerkstoff gefertigt werden, auf deren Oberfläche die Elektroden 3 beispielsweise durch Aufdampfen oder Aufsputtern aufgebrächt werden. Dabei werden die Elektroden 3 vorzugsweise so aufgebracht, daß die Elektroden 3 nicht bis zum Rand der späteren Aktoren 1 reichen, sondern hiervon durch einen vorgegebenen Abstand beabstandet sind. Sodann werden die mit den Elektroden 3 beschichteten Folien gestapelt und miteinander verpreßt. Anschließend wird dieser Stapel aus keramischen Folien gesintert, um eine feste Verbindung der Folien zu erreichen, d. h. die Folien werden zu dem Keramikblock 2 verbacken. Dabei können mehrere Aktoren 1 gleichzeitig gefertigt werden, wobei die einzelnen Aktoren 1 z. B. durch Sägen voneinander getrennt werden. Das Zertrennen der einzelnen Aktoren 1 kann auch bereits vor dem Sintern erfolgen und durch ein Verpressen der einzelnen Aktoren vor dem Sintern kann die wirksame Länge der Aktoren eingestellt werden. Nach dem Zertrennen des Stapels in die einzelnen Aktoren müssen noch die Leiterbahnen 6 an den beiden Querseiten 4 und 5 angebracht werden, um die Elektroden 3 alternierend miteinander zu verbinden.

Bei einer Verwendung der piezoelektrischen Aktoren 1 zur Betätigung eines Brennstoffeinspritzventils ist es vorteilhaft, in dem Aktor 1 eine zentrale Durchströmungsöffnung vorzusehen, durch welche der Brennstoff durch den Aktor 1 hindurchströmen kann. Bislang war es üblich, diese zentrale Durchströmungsöffnung durch einen spanenden Fertigungsschritt, insbesondere Bohren, in den fertigen Aktor einzubringen. Dabei mußte die Innenwandung der Durchströmungsöffnung durch einen Feinbearbeitungsschritt jedoch nachbehandelt werden, um durch das Bohren hervorgerufene Kurzschlüsse zwischen den Elektroden zu beseitigen. Ferner ist es vorteilhaft, die Aktoren 1 mit einer runden Außenkontur zu versehen, um die Aktoren 1 leichter in ein hohlzylindrisches Ventilgehäuse der Brennstoffeinspritzventile integrieren zu können. Durch das Zersägen der Stapel entstehen zunächst jedoch quaderförmige Aktoren 1 mit einer rechteckigen Querschnittsform. Um eine runde Außenkontur zu erzielen, müssen diese rechteckigen Aktoren 1 einem spanenden Verarbeitungsschritt unterworfen werden. Die Nachbehandlung der Aktoren ist deshalb beim Stand der Technik relativ aufwendig. Ferner sind die Durchströmungsöffnungen durch das Bohren nur mit einer runden Innenkontur herstellbar. In der Praxis gibt es jedoch auch Anwendungsfälle, bei welcher es wünschenswert ist, die Durchströmungsöffnungen mit einer anderen Innenkontur auszubilden.

Die Erfindung geht von dem vorstehend beschriebenen Grundverfahren aus und modifiziert dieses wie nachfolgend beschrieben.

Auch bei dem erfindungsgemäßen Verfahren werden zunächst mehrere Folien aus einem piezoelektrischen Keramikwerkstoff hergestellt und diese mit Elektroden 3, beispielsweise durch Aufdampfen oder Sputtern beschichtet. Sodann werden die Folien aufeinandergestapelt und zu einem Stapel verpreßt und gesintert. Schließlich wird der Stapel in die einzelnen Aktoren zerlegt.

Anders als beim Stand der Technik wird die zentrale Durchströmungsöffnung jedoch nicht durch einen nachträglichen spanenden Fertigungsschritt, beispielsweise Bohren, eingebracht. Vielmehr werden in den Folien vor dem Stapeln und vor dem Sintern jeweils Ausnehmungen für jeden Aktor eingebracht und die Folien werden beim Stapeln exakt fluchtend übereinander angeordnet. Die für jeden Aktor 1 vorgesehenen Ausnehmungen bilden beim Übereinanderstapeln der Folien dann die zentrale Durchströmungsöffnung.

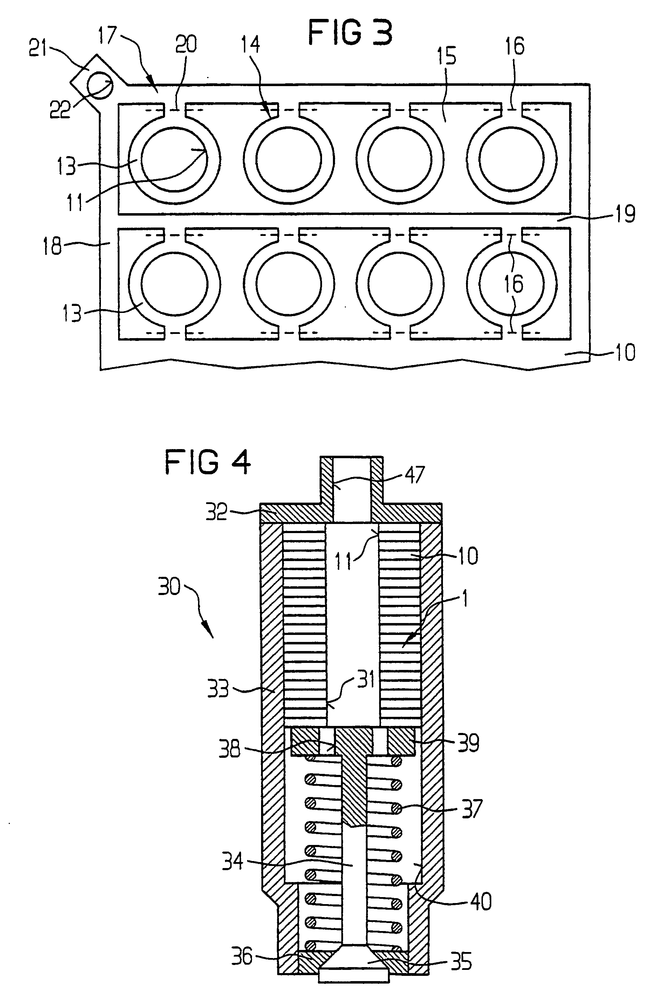

Fig. 2 zeigt ein erstes Ausführungsbeispiel einer erfindungsgemäß ausgebildeten Folie 10 aus einem keramischen Werkstoff. Erkennbar sind die bei dem Ausführungsbeispiel in Fig. 2 runden Ausnehmungen 11. Jede Ausnehmung 11 ist jeweils einem der späteren Aktoren 1 zugeordnet. Dabei weist die Folie 10 mehrere durch die unterbrochenen Linien 12 voneinander getrennte Aktorbereiche 13 auf. Nach dem Übereinanderstapeln der Folien 10 und Sintern der gestapelten Folien 10 werden die Aktorbereiche 13 beispielsweise durch Sägen oder Laserschneiden voneinander getrennt, so daß die einzelnen Aktoren 1 voneinander separiert werden. Wichtig ist die exakte Ausrichtung der einzelnen Folien 10 so übereinander, daß die Ausnehmungen 11 der übereinander angeordneten Folien 10 eine Durchströmungsöffnung mit einer glatten Wandung bilden.

Das Einbringen der Ausnehmungen 11 kann beispielsweise durch Stanzen oder Laserschneiden erfolgen. Die Elektroden 3 können bei dem Beschichtungsschritt ganzflächig auf den Folien 10 aufgebracht werden. In vorteilhafter Weise werden jedoch die Bereiche der Ausnehmungen 11 von der Beschichtung ausgenommen und zwar so, daß die Elektroden 3 durch einen vorgegebenen Abstand a von den Aussparungen 11 beabstandet sind. Weiterhin ist es vorteilhaft, die Elektroden 3 mit Ausnahme von der Seite, an welche die Elektroden 3 mit der Leiterbahn 6 verbunden werden, von der Zertrennungslinie 12 ebenfalls zu beabstanden, so daß die Elektroden 3 sowohl nach außen hin als auch zu der durch die Ausnehmungen 11 gebildeten Durchströmungsöffnung hin isoliert sind.

Fig. 3 zeigt eine Draufsicht auf ein zweites Ausführungsbeispiel einer Folie 10 aus einem piezoelektrischen Keramikwerkstoff, wobei auch hier die piezoelektrischen Aktoren 1 durch Stapeln dieser Folien 10 und nachfolgendes Sintern der Folien 10 hergestellt werden. Im Unterschied zu dem in Fig. 2 dargestellten Ausführungsbeispiel wird nicht nur die durch die Form der Ausnehmungen 11 vorgegebene Innenkontur der Aktoren 1, sondern auch deren Außenkonturen 14 durch Bearbeiten der Folien 10 vor deren Stapeln vorgefertigt. Dazu werden nicht nur die Ausnehmungen 11 aus der Folie 10 beispielsweise durch Laserschneiden oder Stanzen herausgetrennt, sondern auch zusätzliche Elemente 15, so daß die Aktorbereiche 3 nur noch über verbleibende Verbindungsstege 16 mit einem Rahmenbereich 17 der Folie 10 verbunden sind. Das Heraustrennen der Elemente 15 kann ebenfalls durch Laserschneiden oder Stanzen erfolgen.

Der Rahmenbereich 17 der Folie 10 besteht in dem dargestellten Ausführungsbeispiel aus einem außen umlaufenden Außenrahmen 18 und in dem Außenrahmen zeilenartig angeordneten Quersprossen 19. Im oberen Bereich der Fig. 3 sind die kreisringförmig ausgebildeten Aktorbereiche 3 jeweils über einen einzigen Verbindungssteg 16 entweder mit dem Außenrahmen 18 oder den Quersprossen 19 verbunden. Im unteren Bereich der Fig. 3, welcher eine Variation dieses Ausführungsbeispiels zeigt, sind die Aktorbereiche 3 über jeweils zwei diametral gegenüberliegend angeordnete Verbindungsstege 16 mit den Quersprossen 19 oder dem Außenrahmen 18 verbunden. Während die Aktorbereiche 3 entsprechend der in Fig. 3 unten dargestellten Ausgestaltung über die jeweils zwei Verbindungsstege 16 besonders stabil mit dem Rahmenbereich 17 verbunden sind, hat die in Fig. 3 oben dargestellte Ausgestaltung den Vorteil, daß sich die Aktorbereiche 3 durch Durchtrennen des einzigen Verbindungsstegs 16 relativ leicht von dem Rahmenbereich 17 nach dem Zusammenfügen und Sintern der Folien 10 trennen lassen.

Nach dem Zusammenfügen der Folien 10 und nach dem Sintern werden die einzelnen Aktoren 1 aus dem Rahmenbereich 17 beispielsweise durch Ausbrechen, Sägen, Fräsen oder Laserschneiden herausgetrennt. Das Trennen der Aktorbereiche 3 von dem Rahmenbereich 17 erfolgt an durch gestrichelte Linien markierten Trennflächen 20. Entsprechend einer vorteilhaften Ausgestaltung können an den Trennflächen 20 der Verbindungsstege 16 nach dem Durchtrennen die Leiterbahnen 6 zum Verbinden der Elektroden 3 aufgebracht werden.

Um die Folien 10 beim Stapeln exakt fluchtend auszurichten, weist der Rahmen 17 an zumindest zwei Ecken eine Zentrierbohrung 22 auf, die im Ausführungsbeispiel an einem von der Ecke des Rahmens 17 fortragenden Fortsatz 21 ausgebildet ist. Die zumindest zwei Zentrierbohrungen 22 erlauben beispielsweise durch Zusammenwirken mit in die Zentrierbohrungen 22 eingeführten Führungsstangen eine Positionierung der einzelnen Folien 10 exakt übereinander.

Fig. 4 zeigt ein Ausführungsbeispiel eines Brennstoffeinspritzventils 30, das mit einem erfindungsgemäß hergestellten piezoelektrischen Aktor 1 ausgestattet ist, in einer geschnittenen Darstellung. Wie bereits beschrieben, weist der Aktor 1 eine zentrale Durchströmungsöffnung 31 auf, die durch eine Aneinanderreihung der Ausnehmungen 11 in jeder Folie 10 gebildet ist.

Der piezoelektrische Aktor 1 stützt sich an einem Deckelelement 32 eines Ventilgehäuses 33 ab und betätigt eine Ventilnadel 34, an welche im Ausführungsbeispiel einstückig ein Ventilschließkörper 35 angeformt ist. Der Ventilschließkörper 35 bildet zusammen mit einem mit dem Ventilgehäuse 33 verbundenen Ventilsitzkörper 36 einen Dichtsitz. Bei Betätigung des piezoelektrischen Aktors 1 dehnt sich dieser aus und betätigt über die Ventilnadel 34 den Ventilschließkörper 35 so, daß dieser von dem Ventilsitzkörper 36 abhebt und das Brennstoffeinspritzventil 30 öffnet. Wenn die den piezoelektrischen Aktor 1 erregende elektrische Spannung abgeschaltet wird, führt eine Rückstellfeder 37 den Ventilschließkörper 35 wieder in seine Schließposition zurück.

Die Zufuhr des Brennstoffs erfolgt über eine in dem Deckelelement 32 ausgebildete Brennstoffeinlaßöffnung 47. Die weitere Brennstoffführung erfolgt durch die Durchströmungsöffnung 31 des piezoelektrischen Aktors 1 und Durchtrittsöffnungen 38 in einem Flansch 39 der Ventilnadel 34 hindurch in einen Federaufnahmeraum 40, so daß der Brennstoff schließlich zu dem Dichtsitz gelangt. Durch die zentrale Führung des Brennstoffs durch den piezoelektrischen Aktor 1 hindurch, wird die Gestaltung des Brennstoffeinspritzventils 30 wesentlich vereinfacht. Neben kreisförmigen Durchströmungsöffnungen 31 sind mit dem erfindungsgemäßen Herstellungsverfahren ohne weiteres auch andere Innenkonturen der Durchströmungsöffnung 31, beispielsweise eine rechteckige oder sternförmige Innenkontur, herstellbar.

## Patentansprüche

1. Verfahren zur Herstellung mehrerer piezoelektrischer Aktoren (1) mit jeweils einer Durchströmungsöffnung (31) mit folgenden Verfahrensschritten:
- Herstellen von Folien (10) aus einem piezoelektrischen Keramikwerkstoff,
- Beschichten zumindest einer Oberfläche der Folien (10) mit Elektroden (3),
- Stapeln und Verpressen der Folien (10) zu einem Stapel,
- Sintern der gestapelten Folien (10),
- Zertrennen des Stapels in einzelne Aktoren (1),
**dadurch gekennzeichnet,**
**daß** in die Folien (10) vor dem Stapeln und vor dem Sintern zumindest eine Ausnehmung (11) für jeden Aktor (1) eingebracht wird, wobei die Ausnehmungen (11) der Folien (10) beim Stapeln exakt fluchtend übereinander angeordnet werden und so die Durchströmungsöffnung (31) eines jeden Aktors bilden.

2. Verfahren nach Anspruch 1,
**dadurch gekennzeichnet,**
**daß** in den Folien (10) vor dem Stapeln und vor dem Sintern die Außenkonturen (14) der einzelnen Aktoren (1) vorgeformt werden.

3. Verfahren nach Anspruch 2,
**dadurch gekennzeichnet,**
**daß** an den Folien (10) den einzelnen Aktoren (1) zugeordnete Aktorbereiche (13), ein Rahmenbereich (17) und Verbindungsstege (16), die die Aktorbereiche (13) mit dem Rahmenbereich (17) verbinden, ausgebildet werden.

4. Verfahren nach Anspruch 3,
**dadurch gekennzeichnet,**
**daß** jedem Aktorbereich (13) zwei Verbindungsstege (16) zugeordnet werden, die diametral gegenüberliegend angeordnet sind.

5. Verfahren nach Anspruch 3 oder 4,
**dadurch gekennzeichnet,**
**daß** die Aktorbereiche (13) kreisringförmig ausgebildet werden.

6. Verfahren nach einem der Ansprüche 3 bis 5,
**dadurch gekennzeichnet,**
**daß** der Rahmenbereich (17) der Folien (10) so ausgebildet wird, daß dieser einen Außenrahmen (18) und in dem Außenrahmen (18) zeilenartig angeordnete Quersprossen (19) aufweist, wobei die Verbindungsstege (16) die Aktorbereiche (13) mit den Quersprossen (19) oder dem Außenrahmen (18) verbinden.

7. Verfahren nach Anspruch 6,
**dadurch gekennzeichnet,**
**daß** die Folien (10) beim Stapeln mittels an dem Rahmenbereich (17) der Folien (10) vorgesehenen Zentrierbohrungen (22) zentriert werden.

8. Verfahren nach einem der Ansprüche 3 bis 7,
**dadurch gekennzeichnet,**
**daß** die Verbindungsstege (16) nach dem Sintern an einer Trennfläche (20) durchtrennt werden.

9. Verfahren nach Anspruch 8,
**dadurch gekennzeichnet,**
**daß** das Durchtrennen der Verbindungsstege (16) durch Sägen, Fräsen, Laserschneiden oder Ausbrechen erfolgt.

10. Verfahren nach Anspruch 8 oder 9,
**dadurch gekennzeichnet,**
**daß** an der Trennfläche (20) der Verbindungsstege (16) nach dem Durchtrennen zunmindest eine Leiterbahn (6) zum Verbinden der Elektroden (3) aufgebracht wird.

11. Verfahren nach einem der Ansprüche 1 bis 10,
**dadurch gekennzeichnet,**
**daß** das Einbringen der Ausnehmungen (11) durch Stanzen oder Laserschneiden erfolgt.

12. Verfahren nach einem der Ansprüche 1 bis 11,
**dadurch gekennzeichnet,**
**daß** die Elektroden (3) so aufgebracht werden, daß die Elektroden (3) von den Ausnehmungen (11) und/oder von den Außenkonturen (14) der Aktoren (1) durch einen vorgegebenen Abstand (a) beabstandet sind.

## Claims

1. Method for producing a plurality of piezoelectric actuators (1) each with a through-flow opening (31), with the following method steps:
- producing sheets (10) made of a piezoelectric ceramic material,
- covering at least one surface of the sheets (10) with electrodes (3),
- stacking and compressing the sheets (10) into a stack,
- sintering the stacked sheets (10),
- separating the stack into individual actuators (1),
**characterized in that** at least one cavity (11) for each actuator (1) is introduced into the sheets (10) before the stacking and before the sintering, the cavities (11) of the sheets (10) being arranged exactly in line one above the other during stacking, and forming in this way the through-flow opening (31) of each actuator.

2. Method according to Claim 1, **characterized in that** the outer contours (14) of the individual actuators (1) are pre-formed in the sheets (10) before the stacking and before the sintering.

3. Method according to Claim 2, **characterized in that** actuator regions (13) assigned to the individual actuators (1), a frame region (17) and connecting webs (16), which connect the actuator regions (13) to the frame region (17), are formed on the sheets (10).

4. Method according to Claim 3, **characterized in that** two connecting webs (16), which are arranged diametrically opposite each other, are assigned to each actuator region (13).

5. Method according to Claim 3 or 4, **characterized in that** the actuator regions (13) are formed such that they are annular.

6. Method according to one of Claims 3 to 5, **characterized in that** the frame region (17) of the sheets (10) is formed such that it has an outer frame (18) and cross-struts (19) arranged in the manner of rows in the outer frame (18), the connecting webs (16) connecting the actuator regions (13) to the cross-struts (19) or the outer frame (18).

7. Method according to Claim 6, **characterized in that** the sheets (10) are centred during stacking by means of centring bores (22) provided at the frame region (17) of the sheets (10).

8. Method according to one of Claims 3 to 7, **characterized in that** the connecting webs (16) are severed at a separating plane (20) after sintering.

9. Method according to Claim 8, **characterized in that** the severing of the connecting webs (16) takes place by sawing, milling, laser cutting or breaking out.

10. Method according to Claim 8 or 9, **characterized in that**, after the severing, at least one conductor track (6) for connecting the electrodes (3) is applied at the separating plane (20) of the connecting webs (16).

11. Method according to one of Claims 1 to 10, **characterized in that** the introduction of the cavities (11) takes place by punching or laser cutting.

12. Method according to one of Claims 1 to 11, **characterized in that** the electrodes (3) are applied in such a way that the electrodes (3) are spaced apart from the cavities (11) and/or from the outer contours (14) of the actuators (1) by a predetermined distance (a).

## Revendications

1. Procédé de fabrication d'actionneurs piezo-électriques (1) présentant chacun une ouverture de passage (31), selon les étapes suivantes :
- fabrication de feuilles (10) en matériau céramique piezo-électrique,g
- dépôt d'une électrode (3) sur au moins une face de chaque feuille (10),
- empilage et compression des feuilles (10) pour en faire une pile,
- frittage des feuilles empilées (10),
- séparation de la pile en actionneurs individuels (1),
**caractérisé en ce que**
dans chaque feuille (10), avant empilage et frittage, est pratiqué au moins un évidement (11) pour chaque actionneur (1), et les évidements (11), quand on met en pile les différentes feuilles, sont exactement superposés et forment ainsi l'ouverture de passage (31) de chacun des actionneurs.

2. Procédé selon la revendication 1,
**caractérisé en ce que**
dans chaque feuille (10), avant empilage et frittage, les contours externes (14) des actionneurs individuels (1) sont préformés.

3. Procédé selon la revendication 2,
**caractérisé en ce que**
sur chaque feuille (10) sont formées des zones d'actionneur (13) associées aux actionneurs individuels (1), ainsi qu'une zone de cadre (17) et des barrettes de liaison (16) entre les zones d'actionneur (13) et la zone de cadre (17).

4. Procédé selon la revendication 3,
**caractérisé en ce que**
à chaque zone d'actionneur (13) sont associées deux barrettes de liaison (16), diamétralement opposées.

5. Procédé selon la revendication 3 ou 4,
**caractérisé en ce que**
les zones d'actionneur (13) ont la forme d'anneaux circulaires.

6. Procédé selon une des revendications 3 à 5,
**caractérisé en ce que**
la zone de cadre (17) de chaque feuille (10) est constituée de manière à présenter un cadre externe (18) et des barres transversales (19) formant des lignes, les barrettes de liaison (16) reliant les zones d'actionneur (13) aux barres transversales (19) ou au cadre externe (18).

7. Procédé selon la revendication 6,
**caractérisé en ce que**
les feuilles (10) sont, à l'empilage, centrées au moyen de trous de centrage (22) prévus dans la zone de cadre (17) de chaque feuille (10).

8. Procédé selon une des revendications 3 à 7,
**caractérisé en ce que**
les barrettes de liaison (16), après frittage, sont séparées selon une surface de séparation (20).

9. Procédé selon la revendication 8,
**caractérisé en ce que**
la séparation des barrettes de liaison (16) s'effectue par sciage, fraisage, coupe au laser ou arrachement.

10. Procédé selon la revendication 8 ou 9,
**caractérisé en ce que**
après séparation, sur la surface de séparation (20) des barrettes de liaison (16) est déposée au moins une piste conductrice (6) pour relier les électrodes (3).

11. Procédé selon une des revendication 1 à 10,
**caractérisé en ce que**
les évidements (11) sont réalisés par estampage ou coupe au laser.

12. Procédé selon une des revendications 1 à 11,
**caractérisé en ce que**
les électrodes (3) sont séparées des évidements (11) et/ou des contours externes (14) des actionneurs (1) par un intervalle prédéfini (a).
